# EUROPEAN PATENT APPLICATION

(11) **EP 2 315 282 A2**
(43) Date of publication of application: **27.04.2011**
(21) Application number: 10187089.7
(22) Date of filing: 11.10.2010
(51) Int. Cl.: H01L 33/54

(54) **Light emitting apparatus**

(30) Priority: 26.10.2009 TW 098136237
(71) Applicant: GIO Optoelectronics Corp., T'ai nan County 744 (TW)
(72) Inventor: Liao, Kuang-Chiang, 428 Daya Township (TW)
(74) Representative: 2K Patentanwälte Blasberg Kewitz & Reichel

(57) **Abstract**

A light emitting apparatus includes a substrate, at least one LED (light-emitting diode) die (22), a sealant (23), a cover sheet (24) and a protecting material (25). The LED die is disposed on the substrate (21). The sealant covers the LED die and has a top surface and a side surface. The cover sheet is disposed on the top surface of the sealant. The protecting material is disposed at the side surface, and connected with the cover sheet and the substrate. Accordingly, the light emitting apparatus can prevent from moisture or gas that may affect the luminous efficiency thereof, thereby extending the lifetime of the light emitting apparatus.

## Description

### BACKGROUND OF THE INVENTION

### Field of Invention

The present invention relates to a light emitting apparatus and, in particular, to a light emitting apparatus having LED (light-emitting diode).

### Related Art

LED (light-emitting diode) is a light emitting component made of semiconductor materials. It has two electrodes, and when a very small voltage is applied between these electrodes, the electron and holes may combine to transform the residual energy and then emit light.

Differing from the conventional lamp, the LED is a cold light illumination device, which has the advantages of low power consumption, long lifetime, no lamp warm-up time, fast response, etc. In addition, the LED is small size, vibration durable, and suitable for batch production, so it can be applied to manufacture the fine or array module to fit the application requirements. Thus, it has been widely used in the illumination devices, the indicator of information, communication and consuming electronic products, and the backlight module of display devices.

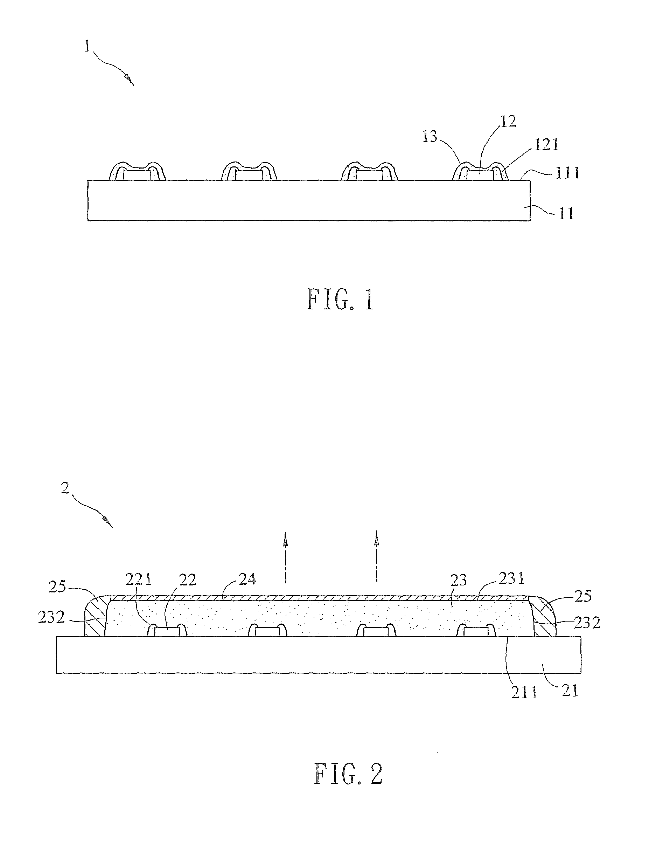

As shown in FIG. 1, a conventional light emitting apparatus 1 containing LED includes a substrate 11, at least one LED die 12, and a sealant 13. In this case, there are four LED dies 12, for example, are disposed on the substrate 11.

The LED die 12 is disposed on the upper surface 111 of the substrate 11 and is electrically connected with the circuit layer (not shown) of the upper surface 11 of the substrate 11 through bonding wires 121. Accordingly, the external circuit can electrically connect to the LED die 12 through the circuit layer for driving the light emitting apparatus 1. The sealant 13 covers the LED die 12 to protect it and prevent the affection of its lighting properties caused by infection of dusts or moistures.

In general, the sealant 13 is made of silica gel. However, the chemical structure of silica gel is not strong enough and it is hydrophilic, so the conventional sealant 13 can not provide a good protection. For example, sulfide, moistures or dusts in the air may enter into the light emitting apparatus 1. If the sulfide in the air enters the light emitting apparatus 1, it may react with the internal elements or circuit containing silver so as to affect the lighting efficiency. If the moistures enter the light emitting apparatus 1, the metal portions therein may be oxidized to form rusts, which will cause short circuit or damage. If the dusts enter the light emitting apparatus 1, the lighting efficiency of the light emitting apparatus 1 will decrease.

Therefore, it is an important subject of the invention to provide a light emitting apparatus with good protection for preventing it from affecting by the external objects such as dusts and moistures, so as to remain the lighting efficiency and extend its lifetime.

### SUMMARY OF THE INVENTION

In view of the foregoing subject, an objective of the invention is to provide a light emitting apparatus with good protection for preventing it from affecting by the external objects so as to remain the lighting efficiency and extend its lifetime.

To achieve the above objective, the present invention discloses a light emitting apparatus including a substrate, at least a LED (light-emitting diode) die, a sealant, a cover sheet, and a protecting material. The LED die is disposed on the substrate. The sealant covers the LED die and has a top surface and a side surface. The cover sheet is disposed on the top surface of the sealant. The protecting material is disposed at the side surface and connected with the cover sheet and the substrate.

In one aspect of the invention, the sealant includes silica gel or a fluorescent material.

In one aspect of the invention, the cover sheet is light permeable and includes a fluorescent material.

In one aspect of the invention, the light emitting apparatus further includes a reflective layer disposed on the cover sheet.

In one aspect of the invention, the protecting material includes epoxy pr an O-ring.

In one aspect of the invention, the cover sheet and the protecting material are made of the same material.

In one aspect of the invention, the light emitting apparatus further includes a reflective layer disposed on the substrate.

In one aspect of the invention, the LED die is connected with the substrate by wire bonding.

In one aspect of the invention, the LED die is connected with the substrate by flip-chip bonding.

As mentioned above, the light emitting apparatus of the invention is configured with a cover sheet disposed on the top surface of the sealant and a protecting material disposed at the side surface of the sealant, and the protecting material is connected with the cover sheet and the substrate. Accordingly, the cover sheet and protecting material can tightly cover the sealant so as to prevent the sulfide, moistures or dusts in the air from entering into the light emitting apparatus, thereby avoiding the reaction of silver and sulfide, oxidization of moistures, or pollution of dusts. Thus, the lighting efficiency of the light emitting apparatus can be maintained, and the short circuit caused by the oxidization can be prevented so as to extend the lifetime of the product.

### BRIEF DESCRIPTION OF THE DRAWINGS

The invention will become more fully understood from the detailed description and accompanying drawings, which are given for illustration only, and thus are not limitative of the present invention, and wherein:

FIG. 1 is a cross-sectional diagram of a conventional light emitting apparatus;

FIG. 2 is a cross-sectional diagram of a light emitting apparatus according to an embodiment of the present invention;

FIG. 3 is a cross-sectional diagram of a light emitting apparatus according to another aspect of the embodiment of the present invention;

FIG. 4 is a cross-sectional diagram of a light emitting apparatus according to another aspect of the embodiment of the present invention;

FIG. 5 is a cross-sectional diagram of a light emitting apparatus according to another aspect of the embodiment of the present invention; and

FIG. 6 is a cross-sectional diagram of a light emitting apparatus according to another embodiment of the present invention.

### DETAILED DESCRIPTION OF THE INVENTION

The present invention will be apparent from the following detailed description, which proceeds with reference to the accompanying drawings, wherein the same references relate to the same elements.

FIG. 2 is a cross-sectional diagram of a light emitting apparatus according to an embodiment of the present invention. Referring to FIG. 2, a light emitting apparatus 2 includes a substrate 21, at least a LED (light-emitting diode) die 22, a sealant 23, a cover sheet 24, and a protecting material 25. The light emitting apparatus 2 of the invention can be applied to, for example but not limited to, illumination devices, indicators of information, communication and consuming electronic products, backlight modules, display devices, or media boards.

To be noted, the amount and arrangement of the LED dies 22 of the light emitting apparatus 2 are not limited. In this embodiment, the light emitting apparatus 2 includes four LED dies 22, which are arranged linearly in one dimension on the substrate 21. Of course, the arrangement of the LED dies 22 can be various depending on the requirements. For example, the substrate 21 can be disposed with only one LED die 22, or with a plurality of LED dies 22 arranged in two dimensions.

The LED dies 22 can be, for example, disposed on the substrate 21 by wire bonding or flip-chip bonding. In this embodiment, the LED dies 22 is formed on the substrate 21 and connected with the circuit layer on the top surface 211 of the substrate 21 by wires 221.

The substrate 21 can be, for example, a circuit board or a lead frame. In this embodiment, the substrate 21 is a circuit board. The substrate 21 can be made of, for example but not limited to, glass, metal, ceramics, glass fiber, or resin.

The sealant 23 covers the entire LED dies 22 to protect it. In this case, the sealant 23 has a top surface 231 and a side surface 232. The top surface 231 can be formed as a planar surface by following polishing process or etching process, so that he cover sheet 24 can be easily attached on the top surface 231. The sealant 23 is made of a light-permeable material such as silica gel or epoxy. In addition, the sealant 23 may include fluorescent material, which can emit light after irradiated by the light from the LED dies 22. Then, the light emitted from the LED dies 22 and the light emitted from the fluorescent material are mixed to generate desired color of light (e.g. white light). Of course, the fluorescent material can be configured at any possible light path such as the cover sheet 24, the protecting material 25, or the substrate 21.

The cover sheet 24 is disposed on the top surface 231 of the sealant 23. In this embodiment, the top surface 231 is substantially a planar surface, so that the cover sheet 24 can be attached thereon easily. The shape of the cover sheet 24 can be a film that is flexible or a plate that is nonflexible. In addition, the cover sheet 24 can be made of a light-permeable material, such as plastic, resin, or glass. In this case, the cover sheet 24 is for example a tape with water-proof property, which can be made of polymer material such as polyethylene (PE). PE is a hydrophobic material that can isolate sulfide, moistures, or dusts so as to prevent it entering the light emitting apparatus 2. Of course, PE is only an example for the material of the cover sheet 24, and in practice, the cover sheet 24 can be made of other materials such as epoxy.

The cover sheet 24 is disposed on the top surface 231 of the sealant 23 for protecting the sealant 23 and the LED dies 22 from being affected by the sulfide, moistures or dusts in the air, thereby avoiding the reaction of silver and sulfide, oxidization of moistures, or pollution of dusts. Thus, the lighting efficiency of the light emitting apparatus 2 can be maintained, the short circuit caused by the oxidization can be prevented, and the lighting property can be kept to allow the light emitted from the LED dies 22 to pass through the cover sheet 24. In addition, the cover sheet 24 may include a fluorescent material so that the light emitting apparatus 2 can generate the desired color light. For example, if the cover sheet 24 is made of glass, a fluorescent layer can be formed on the cover sheet 24; otherwise, if the cover sheet 24 is a tape, the tape can be a fluorescent tape.

The protecting material 25 is disposed at the side surface 232 of the sealant 23, and is connected with the cover sheet 24 and the substrate 21. For example, the protecting material 25 can be formed by dispensing around the side surface 232 of the sealant 23. In this case, the protecting material 25 may include hydrophobic polymer such as epoxy or PE. In other words, the protecting material 25 and the cover sheet 24 can be made of the same material. In addition, the protecting material 25 and the cover sheet 24 can be a single component that is integrally formed as one piece for covering the top surface 231 and side surface 232 of the sealant 23 and connecting with the substrate 21, thereby preventing the external objects entering into the sealant 23. In this embodiment, the protecting material 25 is made of epoxy, and is disposed on the surface of the substrate 21 with a dimension larger than that of the protecting material 25.

In addition, the protecting material 25 can be an O-ring disposed around the side surface 232 of the sealant 23 and connected with the substrate 21 for preventing external objects entering through the side surface 232 of the sealant 23.

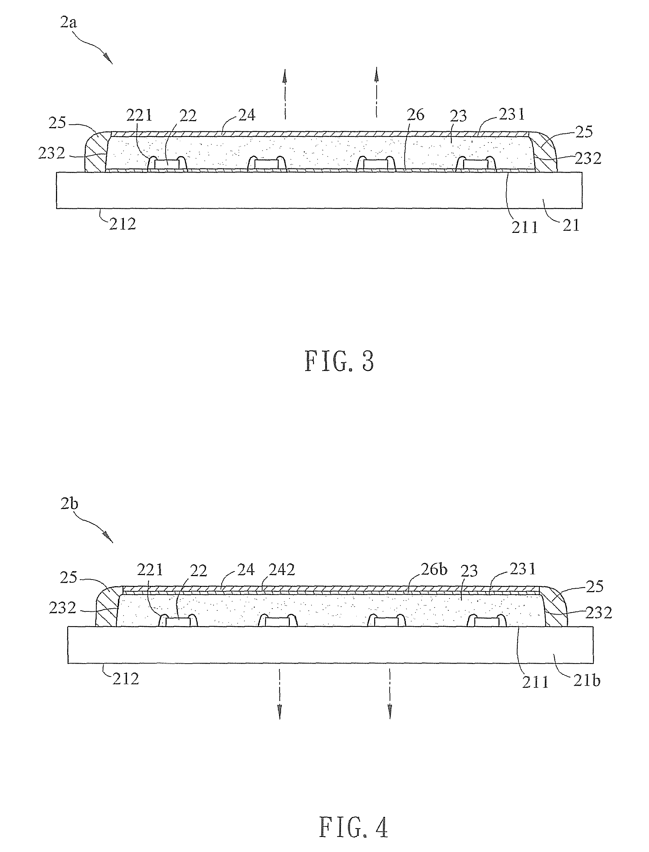

With reference to FIG. 3, another light emitting apparatus 2a further includes a reflective layer 26 disposed on the substrate 21. In this embodiment, the reflective layer 26 is disposed on a portion of the top surface 211 without configured with the circuit layer, and is used to reflect the light emitted from the LED dies 22 to the substrate 21. The reflective layer 26 is made of the material with high reflective coefficient such as metal (e.g. silver), alloy, or a mixture of TiO₂ and resin. Thus, the reflective layer 26 formed on the top surface 211 of the substrate 21 can form a surface for reflecting the light emitted from the LED dies 22, thereby obtaining a better light usage.

The LED dies 22 of the invention can be disposed over parts of the substrate 21, which are formed with or without the reflective layer 26. In this embodiment, the LED dies 22 are disposed on the reflective layer 26.

To be noted, the reflective layer of the embodiment can be located at different positions depending on various requirements. For example, it can be disposed on the bottom surface 212 of the substrate 21, or at the side surface 232 and/or the top surface 231 of the sealant 23.

FIG. 4 is a cross-sectional diagram of a light emitting apparatus 2b according to another aspect of the embodiment of the present invention. As shown in FIG. 4, the substrate 21b is a transparent glass substrate, and the reflective layer 26b is disposed on the bottom surface 242 of the cover sheet 24 and is connected with the top surface 231 of the sealant 23. In other words, the reflective layer 26b can be disposed between the sealant 23 and the cover sheet 24. Of course, it is possible to further dispose another reflective layer (not shown) at the side surface 232 of the sealant 23 for reflecting the light emitted from the LED dies 22 towards the substrate 21b.

To be noted, because the reflective layer 26b is disposed between the sealant 23 and the cover sheet 24, the cover sheet 24 does not contain the fluorescent material but the sealant 23 contains the fluorescent material. Accordingly, the light emitted from the LED dies 22 can irradiate the fluorescent material of the sealant 23 so as to generate desired color light. In addition, the fluorescent material can be disposed at any position on the light path such as the top surface 211 or the bottom surface 212 of the substrate 21b.

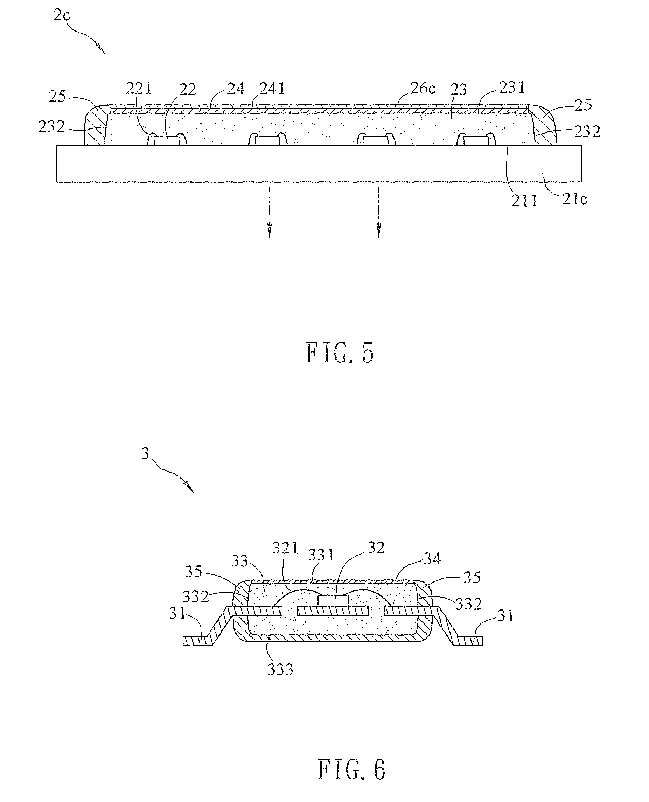

FIG. 5 is a cross-sectional diagram of a light emitting apparatus 2c according to another aspect of the embodiment of the present invention. As shown in FIG. 5, the substrate 21c is also a transparent glass substrate, and the reflective layer 26c is disposed on the top surface 241 of the cover sheet 24 for reflecting the light emitted form the LED dies 22 to the substrate 21c. Of course, it is also possible to further dispose another reflective layer (not shown) at the side surface 232 of the sealant 23 for reflecting the light emitted from the LED dies 22 towards the substrate 21c.

In this case, because the reflective layer 26c is disposed on the top surface 241 of the cover sheet 24, the cover sheet 24 and/or the sealant 23 may contain the fluorescent material. Accordingly, the light emitted from the LED dies 22 can irradiate the fluorescent material of the cover sheet and/or the sealant 23 so as to generate desired color light. Of course, the fluorescent material can be disposed on the top surface 211 or the bottom surface 212 of the substrate 21 c.

FIG. 6 is a cross-sectional diagram of a light emitting apparatus 3 according to another embodiment of the present invention. As shown in FIG. 6, the major difference between the light emitting apparatus 3 and the above-mentioned light emitting apparatus 2 is that the light emitting apparatus 3 includes only one LED die 32, the substrate 31 is a lead frame, and the protecting material 35 is disposed at the side surface 332 and the bottom surface of the sealant 33 and connected with the cover sheet 34. Of course, it is possible to configure a plurality of LED dies 32 on the substrate 32.

Due to the configuration of the cover sheet 34 and the protecting material 35, which cover the sealant 33, it is possible to prevent the light emitting apparatus 3 from being affected by the sulfide, moistures, or dusts in the air. Thus, the reaction of silver and sulfide, oxidization of moistures, or pollution of dusts inside the light emitting apparatus 3 can be avoided, thereby maintaining the lighting efficiency of the lighting emitting apparatus 3 and protecting it from short circuit.

In summary, the light emitting apparatus of the invention is configured with a cover sheet disposed on the top surface of the sealant and a protecting material disposed at the side surface of the sealant, and the protecting material is connected with the cover sheet and the substrate. Accordingly, the cover sheet and protecting material can tightly cover the sealant so as to prevent the sulfide, moistures or dusts in the air from entering into the light emitting apparatus, thereby avoiding the reaction of silver and sulfide, oxidization of moistures, or pollution of dusts. Thus, the lighting efficiency of the light emitting apparatus can be maintained, and the short circuit caused by the oxidization can be prevented so as to extend the lifetime of the product.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. A light emitting apparatus, comprising:
a substrate;
at least a LED (light-emitting diode) die disposed on the substrate;
a sealant covering the LED die and having a top surface and a side surface;
a cover sheet disposed on the top surface of the sealant; and
a protecting material disposed at the side surface, and connected with the cover sheet and the substrate.

2. The light emitting apparatus according to claim 1, wherein the substrate is a circuit board or a lead frame.

3. The light emitting apparatus according to claim 1 or 2, wherein the substrate is made of glass, metal, ceramics, glass fiber, or resin.

4. The light emitting apparatus according to any of the preceding claims, wherein the sealant comprises silica gel.

5. The light emitting apparatus according to any of the preceding claims, wherein the sealant comprises a fluorescent material.

6. The light emitting apparatus according to any of the preceding claims, wherein the top surface is substantially a planar surface.

7. The light emitting apparatus according to any of the preceding claims, wherein the cover sheet is light permeable.

8. The light emitting apparatus according to any of the preceding claims, further comprising:
a reflective layer disposed on the cover sheet.

9. The light emitting apparatus according to any of the preceding claims, wherein the cover sheet comprises a fluorescent material.

10. The light emitting apparatus according to any of the preceding claims, wherein the protecting material comprises epoxy.

11. The light emitting apparatus according to any of claims 1 to 9, wherein the protecting material comprises an O-ring.

12. The light emitting apparatus according to any of the preceding claims, wherein the cover sheet and the protecting material are made of the same material.

13. The light emitting apparatus according to any of the preceding claims, further comprising:
a reflective layer disposed on the substrate.

14. The light emitting apparatus according to any of the preceding claims, wherein the LED die is connected with the substrate by wire bonding.

15. The light emitting apparatus according to any of claims 1 to 13, wherein the LED die is connected with the substrate by flip-chip bonding.
